# EUROPEAN PATENT APPLICATION

(11) **EP 3 349 358 A1**
(43) Date of publication of application: **18.07.2018**
(21) Application number: 16844472.7
(22) Date of filing: 09.09.2016
(51) Int. Cl.: H03K 17/16, H01L 21/8232, H01L 21/8234, H01L 27/06, H01L 27/088, H03K 17/687

(54) **POWER DEVICE**

(30) Priority: 10.09.2015 JP 2015178375
(71) Applicant: Furukawa Electric Co. Ltd., Tokyo 100-8322 (JP); Furukawa Automotive Systems Inc., Inukami-gun, Shiga 522-0242 (JP)
(72) Inventor: TAMURA Ryosuke, Tokyo 100-8322 (JP); SUGIMOTO Kaoru, Tokyo 100-8322 (JP); KAYA Syusuke, Tokyo 100-8322 (JP)
(74) Representative: Weickmann & Weickmann PartmbB
(86) International application number: PCT/JP2016/076540
(87) International publication number: WO 2017/043611

(57) **Abstract**

There is provided a power device capable of easily designing a switching circuit that takes measures against high frequency noise while maintaining a switching speed without change.

The power device (10, 10A to 10D) includes a normally-on type first transistor (12), a normally-off type second transistor (14), and an electric path (16) that forms a cascode connection between the first transistor (12) and the second transistor (14), and contains an inductance component (32).

## Description

### Technical Field

The present invention relates to a power device formed by cascode-connecting a normally-on type first transistor and a normally-off type second transistor.

### Background Art

Conventionally, there has been developed a moving body using electric power as a drive source, such as a power conversion device (hereinafter referred to as a "power device") suited to a power source system of an electric vehicle, for example. Recently, various mounting techniques have been proposed to achieve miniaturization and high efficiency while overcoming drawbacks encountered in a transistor using a wide band gap (WBG) semiconductor.

In Japanese Patent No. 5012930 (Fig. 1, Fig. 3, Fig. 5 to Fig. 8, etc.), a device is proposed in which a normally-on type first transistor (SiC-JFET) is connected in cascode with a normally-off type second transistor (Si-MOSFET), and an RC circuit is provided between a gate of the first transistor and a source of the second transistor for regulating a switching speed. It is further disclosed that the switching loss can be reduced while suppressing occurrence of resonance (e.g., surge) by time control of the switching speed.

### SUMMARY

In such a power device, it is important to take measures against high frequency noise that occurs due to various causes in order to perform the stable switching operation at a high speed. Since it is unavoidable that the operation frequency of the power device increases along with the enhanced performance of an object (e.g., an electric vehicle) on which the power device is to be mounted, it is expected that the importance of the measures against noise are further increased.

According to a control method proposed in Japanese Patent No. 5012930, a surge is suppressed by slowing down the switching speed of the normally-on device that is connected in cascode in a latter part of a switching period. However, in this control method, since the switching speed is slowed down in the latter part of the switching period, it is needless to say that the switching loss is correspondingly increased.

A further problem is that a circuit configuration disclosed in Japanese Patent No. 5012930 includes an RC circuit functioning as a high-pass filter. Since the high-pass filter passes many frequency components belonging to the high frequency band, it is necessary to design the filter by increasing a cutoff frequency every time the frequency of the noise component to be addressed is increased. Therefore, inconvenience is caused because the design of the switching circuit becomes extremely complicated.

As another measure against surge in prior art, ferrite beads are inserted into a gate of the cascode circuit to suppress the surge of the gate, thereby also suppressing the surge of the drain current. However, in a device using a GaN-based compound semiconductor, even when the ferrite beads are inserted into the gate of the cascode circuit, rather than suppressing the surge of the gate, the surge of the drain current is increased, so that the effect of suppressing the surge cannot be sufficiently obtained as the entire circuit.

The present invention has been made in view of the above described problems, and it is an object of the present invention to provide a power device capable of easily designing a switching circuit that takes measures against high frequency noise while maintaining a switching speed without change.

A "power device" according to the present invention comprises:
a normally-on type first transistor that uses a GaN-based compound semiconductor, the normally-on type first transistor including a first gate, a first source, and a first drain;
a normally-off type second transistor including a second gate, a second source, and a second drain; and
an electric path that forms cascode connections between the first gate of the first transistor and the second source of the second transistor, and between the first source of the first transistor and the second drain of the second transistor, and contains an inductance component between the first transistor and the second transistor.

Since the electric path forming the cascode connection between the first transistor and the second transistor contains an inductance component as described above, a filtered voltage is applied to the cascode connection side, and the filter includes a filter that reflects the frequency characteristic of the inductance component, and a high frequency filter that cuts off many frequency components belonging to the high frequency band. Even when the frequency of the noise component to be addressed is increased, it is not necessary to greatly change the filter as long as the frequency is higher than a cutoff frequency. Thus, it is possible to easily design the switching circuit that takes measures against high frequency noise while maintaining the high switching speed without change.

It is more preferable to provide the inductance component in the electric path between the first gate of the first transistor and the second source of the second transistor. When the inductance component is thus disposed in the electric path, the effect of suppressing the surges of both of the gate terminal and the drain terminal can be obtained without impairing the switching speed.

It is preferable that the inductance component is an inductor having the frequency characteristic of suppressing or removing the surge that occurs along with the switching operation. Thus, the inductance component is hardly affected by the surge that occurs along with the switching operation.

It is preferable that the inductance component comprises a plurality of inductors having the frequency characteristics different from each other, the plurality of inductors are connected to each other in parallel on the electric path, and a plurality of diodes of which rectifying action directions do not coincide with each other are connected to the respective plurality of inductors in series. The high frequency filters different depending on the charge/discharge direction can be selected by the rectifying actions of the diodes. An inverse voltage of the inductors is reduced, thereby capable of preventing an excess voltage from being applied to the second source of the second transistor.

It is preferable that the inductance component comprises a plurality of inductors having the frequency characteristics different from each other, and the plurality of inductors are connected to each other in series on the electric path. The ranges of the frequency characteristics can be mutually covered, as a result, an effective band width of the high frequency filter can be substantially increased.

It is preferable that the inductance component be a magnetic member that is disposed or formed on a gate electrode pad included in the first transistor. Alternatively, it is also preferable that the inductance component is a microstrip line that is formed on the gate electrode pad included in the first transistor. Alternatively, it is also preferable that the inductance component is a portion of an electric wire included in the electric path, and the portion of the electric wire has different thickness, length, line width or shape from that of the remaining portions of the electric wire.

In each embodiment, the efficient arrangement can be achieved with a small number of electronic elements, and therefore the device size and the manufacturing cost can be reduced.

According to a power device of the present invention, it is possible to easily design a switching circuit that takes measures against high frequency noise while maintaining a high switching speed without change.

### Brief Description of Drawings

Fig. 1 is an electric circuit diagram of a power device common to each embodiment.
Fig. 2 is an electric circuit diagram of a power device according to a first embodiment.
Fig. 3A and Fig. 3B each are a cross-sectional view illustrating an exemplified structure of a first transistor in Fig. 2.
Fig. 4 is an electric circuit diagram of a power device according to a second embodiment.
Fig. 5 is a cross-sectional view illustrating an exemplified structure of a first transistor in Fig. 4.
Fig. 6 is a schematic graph showing a first effect by an inductance component.
Fig. 7A and Fig. 7B each are a schematic graph showing a second effect by an inductance component.
Fig. 8 is an electric circuit diagram of a power device according to a third embodiment.
Fig. 9 is an electric circuit diagram of a power device according to a fourth embodiment.
Fig. 10 is a schematic graph showing a frequency characteristic of each inductor of Fig. 9.

### DETAILED DESCRIPTION

Hereinafter, preferable embodiments of a power device according to the present invention will be described with reference to the accompanying drawings.

### [Configuration of Power Device 10 Common to Each Embodiment]

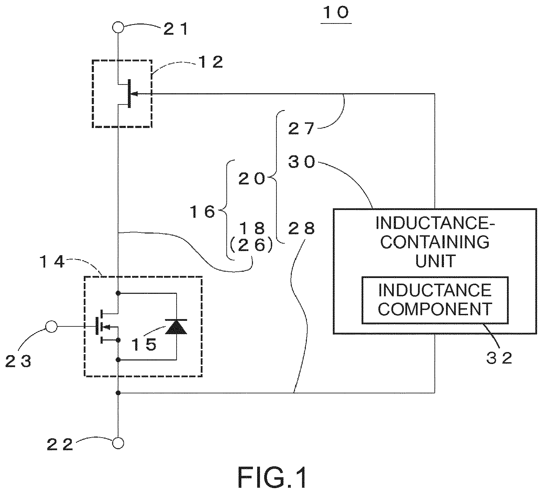

Fig. 1 is an electric circuit diagram of a power device 10 common to each embodiment. The power device 10 is a device that is applied to a power source system of an electric vehicle using electric power as a drive source, for example, and the configuration and the application of the power device 10 are not limited to this example.

The power device 10 is formed to include a normally-on type first transistor 12, a normally-off type second transistor 14, and an electric path 16 (more particularly, path portions 18, 20) forming a cascode connection between the first transistor 12 and the second transistor 14. The first transistor 12 includes a first gate (G), a first source (S), and a first drain (D), and the second transistor 14 includes a second gate (G), a second source (S), and a second drain (D).

As used herein, the "normally-on type" means a type in which a current "flows" between a source (S) and a drain (D) under a condition where a voltage is not applied to a gate (G) (normal condition). In contrast, the "normally-off type" means a type in which a current "does not flow" between the source (S) and the drain (D) under a condition where the voltage is not applied to the gate (G) (normal condition).

The first transistor 12 includes a junction field effect transistor (JFET) using a wide band gap (WBG) semiconductor that is a GaN-based compound semiconductor containing gallium nitride (GaN), for example. Alternatively, the first transistor 12 may be a high electron mobility transistor (HEMT).

The second transistor 14 includes a MOS (Metal-Oxide-Semiconductor)-type FET using silicon (Si), for example. A pn-junction-type parasitic diode 15 is interposed between the second source (S) and the second drain (D) of the second transistor 14.

As understood from Fig. 1, the first drain (D) of the first transistor 12, the second source (S) of the second transistor 14, and the second gate (G) of the second transistor 14 are connected to a drain terminal 21, a source terminal 22, and a gate terminal 23, respectively. The first source (S) of the first transistor 12 is connected to the second drain (D) of the second transistor 14 through a path portion 18. The first gate (G) of the first transistor 12 is connected to the second source (S) of the second transistor 14 through the path portion 20.

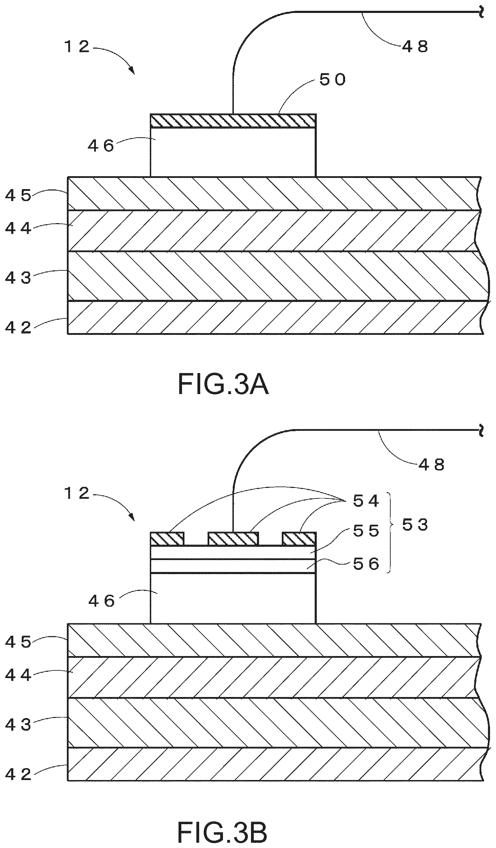

The path portion 18 is comprised of a conductive electric wire 26 including a bonding wire 48 (Figs. 3A and 3B). The path portion 20 includes a conductive electric wire 27 that is connected to the first transistor 12, a conductive electric wire 28 that is connected to the second transistor 14, and an inductance-containing unit 30 that is disposed between the electric wires 27 and 28. In addition to or separately from this inductance-containing unit 30, an inductance-containing unit 30 may be provided on the path portion 18 side. The inductance-containing unit 30 may be directly connected to the first transistor 12 (the second transistor 14) without being connected by means of the electric wire 27 (28).

The inductance-containing unit 30 is an inductance component 32 that is significantly larger than a parasitic inductance of the entire electric path 16 or includes the inductance component 32. Thus, note that unintentional minute inductances (e.g., parasitic inductances of electric wires 26 to 28) on circuit design are not contained in the inductance component 32.

### [First Embodiment]

### <Configuration of Power Device 10A>

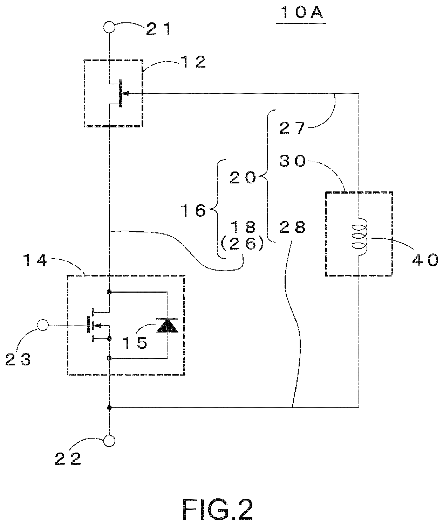

A configuration of a power device 10A according to a first embodiment will be described with reference to Figs. 2, 3A and Fig. 3B. An inductance-containing unit 30 of the power device 10A illustrated in Fig. 2 includes an inductor 40. In other words, an inductance component 32 is one inductor 40.

Fig. 3A is a cross-sectional view illustrating an exemplified structure of a first transistor 12 in Fig. 2. More particularly, Fig. 3A is an enlarged cross-sectional view of a main part including a gate electrode pad 46 of the first transistor 12. A well-known configuration disclosed in Japanese Patent Application Laid-Open No. 2008-66553, for example, can be variously applied to the whole configuration of the power device 10A including the other portions.

The first transistor 12 is formed by laminating a substrate 42, an electron transit layer 43, an electron supply layer 44, an interlayer insulation film 45, and a gate electrode pad 46 in this order from the lower side to the upper side in Fig. 3A. The first transistor 12 uses a GaN-based compound semiconductor, and typically, the substrate 42 is made of a material containing Si or SiC, the electron transit layer 43 is made of a material containing a non-doped GaN, the electron supply layer 44 is made of a material containing AlGaN (aluminum gallium nitride), and the interlayer insulation film 45 is made of a material containing SiO₂ (silicon dioxide).

The gate electrode pad 46 is electrically connected to a lead frame (not illustrated) through a bonding wire 48 made of gold, silver, aluminum, etc. A magnetic thin film 50 is formed on the gate electrode pad 46, the magnetic thin film 50 functioning as the inductor 40 in Fig. 2. The magnetic thin film 50 is formed of a magnetic body such as ferrite, using various well-known deposition methods including vapor deposition.

Thus, the inductance component 32 may be a magnetic member that is formed on the gate electrode pad 46 included in the first transistor 12, and may be specifically the magnetic thin film 50. In this case, the efficient arrangement can be achieved with a small number of electronic elements, and therefore the device size and the manufacturing cost can be reduced.

As illustrated in Fig. 3B, the inductance component 32 may be, for example, a microstrip line 53 having a meander structure that is formed on the gate electrode pad 46 included in the first transistor 12. The microstrip line 53 has a circuit structure that is formed of a conductive foil (GND) 56 formed on a bottom surface of a substrate 55, and linear conductive foils (transmission line) 54 formed on a top surface of the substrate 55. Even with this configuration, it is possible to achieve the same operation and effects as the configuration described above with a small number of electronic elements.

The inductance component 32 may be a portion of the electric wire 27 (28) included in the electric path 16. In this case, the electric wire 27 (28) is designed so that the portion of the electric wire 27 (28) has different thickness, length, line width or shape from that of the remaining portions of the electric wire 27 (28). Specifically, the design method includes designing not only the thickness or length of the bonding wire 48 but also the length or line width of a wiring pattern (not illustrated). The inductance may be adjusted by changing the shape of the bonding wire 48 (e.g., by winding the bonding wire 48 into a coil shape). Even with this configuration, it is possible to achieve the same operation and effects as the configuration described above with a small number of electronic elements.

### <Effect by Power Device 10A>

Since an impedance of the inductor 40 is higher on a high frequency side, a surge having a frequency higher than a switching frequency can be prevented from occurring without obstructing the switching of the power device 10A.

### [Second Embodiment]

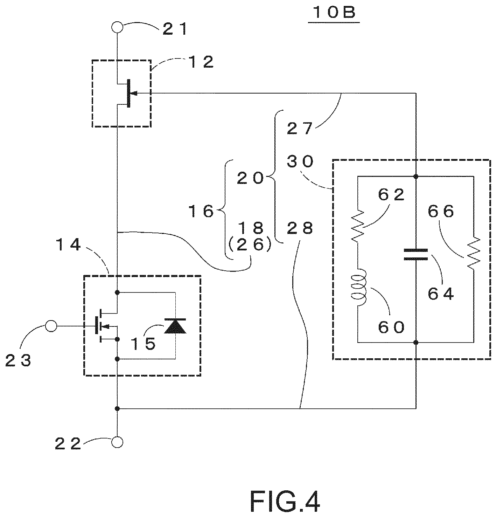

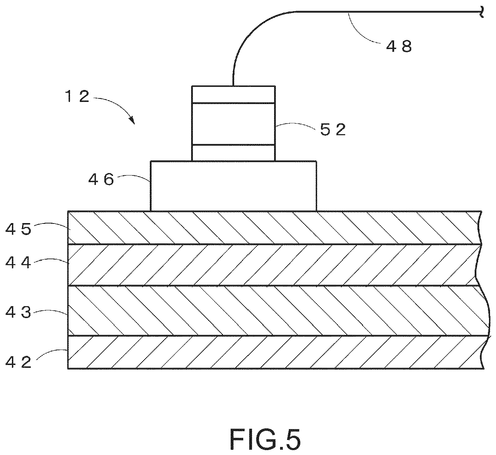

A power device 10B according to a second embodiment will be described with reference to Fig. 4 and Fig. 5. An inductance-containing unit 30 of the power device 10B includes an inductor 60, a resistor 62 that is connected to the inductor 60 in series, a capacitor 64 and a resistor 66. Each of the capacitor 64 and the resistor 66 is connected in parallel to the series circuit of the inductor 60 and the resistor 62. In other words, an inductance component 32 is one inductor 60.

Thus, the inductance-containing unit 30 is not limited to an L-circuit (first embodiment), and may be a combination circuit including the other electronic elements (R and/or C). The design flexibility of a switching circuit that takes measures against high frequency noise is enhanced as compared with the power device 10A of the first embodiment.

Note that the inductance-containing unit 30 (Fig. 4) may be formed by combining electronic components (including a function of L) each having a function of L, R or C, or may be formed of a material (a chip bead 52 of Fig. 5) having an electric property that can be expressed using an equivalent circuit model.

Fig. 5 is a cross-sectional view illustrating an exemplified structure of a first transistor 12 in Fig. 4. Fig. 5 is an enlarged cross-sectional view of a main part including a gate electrode pad 46 of the first transistor 12, similarly to Fig. 3A. As described above, a well-known configuration can be variously applied to the whole configuration of the power device 10B including the other portions.

The first transistor 12 is formed by laminating a substrate 42, an electron transit layer 43, an electron supply layer 44, an interlayer insulation film 45, and a gate electrode pad 46 in this order from the lower side to the upper side in Fig. 5A. The gate electrode pad 46 is electrically connected to a lead frame (not illustrated) through a bonding wire 48. The chip bead 52 functioning as the inductor 60 and the resistor 62 (that are connected to each other in series) in Fig. 4 is disposed on the gate electrode pad 46.

The tubular chip bead 52 is formed of a magnetic body such as ferrite, and the bonding wire 48 is inserted into the tubular chip bead 52. Note that the chip bead 52 may have a laminate structure in which two types of magnetic sheets on which (a half of) a spiral conductor pattern is printed are alternately disposed.

Thus, the inductance component 32 may be a magnetic member that is disposed on the gate electrode pad 46 included in the first transistor 12, and may be specifically the chip bead 52. In this case, the efficient arrangement can be achieved with a small number of electronic elements, and therefore the device size and the manufacturing cost can be reduced.

Note that in Fig. 5, the chip bead 52 is disposed on the gate electrode pad 46, but the arrangement is not limited to this specific example. For example, the chip bead 52 may be disposed on a side of the electric wires 27, 28 between the first gate (G) of the first transistor 12 and the second source (S) of the second transistor 14, or may be disposed on a side of the path portion 18 between the first source (S) of the first transistor 12 and the second drain (D) of the second transistor 14.

### <Surge Suppressing Effect>

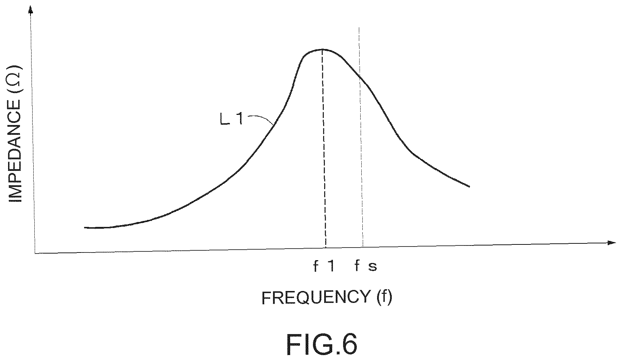

An effect by the inductance component 32 whereby surges are suppressed will be described with reference to Fig. 6 from the viewpoint of the frequency characteristic. For example, it is assumed that surge occurs in a voltage or current waveform along with the switching operation of the power device 10B. This surge waveform has a frequency characteristic (a so-called power spectrum) including a surge frequency fs as a principal component.

Fig. 6 is a schematic graph showing a first effect by the inductance component 32, more particularly, is a graph showing a frequency characteristic of the power device 10B. The abscissa of the graph represents a frequency (f; Hz in unit), and the ordinate represents an impedance (Ω in unit) of the inductance-containing unit 30. Note that in an example of Fig. 6, the impedance is adopted as a physical quantity (ordinate) of the "frequency characteristic," but the ordinate may represent an inductance (H in unit).

This frequency characteristic L1 represents a band rejection filter having one peak centering on a peak frequency f1. The impedance is increased as the frequency comes closer to the peak frequency f1. Thus, the effect of suppressing or removing the surge is improved as the surge frequency fs comes closer to the peak frequency f1. If the surge frequency fs is thus known, it is desirable to introduce the inductance-containing unit 30 having the frequency characteristic L1 in which a value of a frequency difference |fs-f1| is close to zero.

As described above, a filtered voltage is applied to the cascode connection side containing the inductance component 32, and the filter includes a filter that reflects the frequency characteristic (L1) of the inductance component 32, and a high frequency filter that cuts off many frequency components belonging to the high frequency band.

Even when the frequency of the noise component to be addressed is increased, it is not necessary to greatly change the filter as long as the frequency is higher than a cutoff frequency. Thus, it is possible to easily design the switching circuit that takes measures against high frequency noise while maintaining the high switching speed without change.

It is preferable to provide the inductance component 32 in an electric path (i.e., the path portion 20) between the first gate (G) of the first transistor 12 and the second source (S) of the second transistor 14. When the inductance component 32 is thus disposed in the electric path, the effect of suppressing the surges of both the gate terminal 23 and the drain terminal 21 can be obtained without impairing the switching speed.

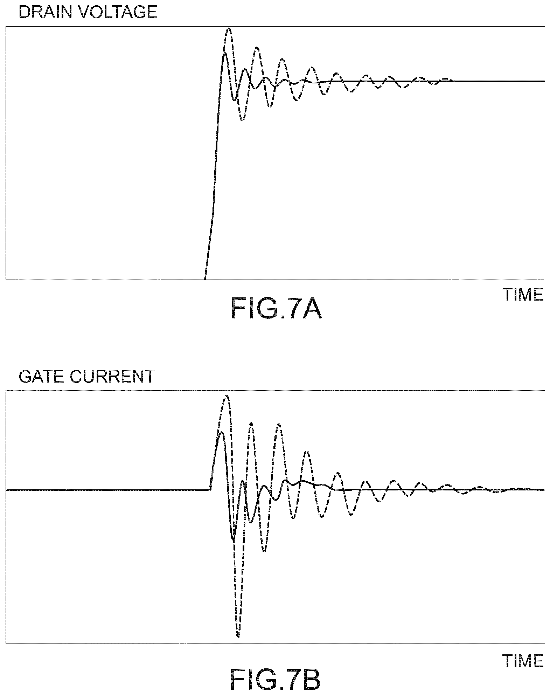

The surge suppressing effect by the inductance component 32 will be described with reference to Figs. 7A and 7B from the viewpoint of the waveforms. More particularly, Fig. 7A is a waveform chart of a drain voltage measured depending on the presence or absence of the inductance-containing unit 30, and Fig. 7B is a waveform chart of a gate current measured depending on the presence or absence of the inductance-containing unit 30.

A graph indicated by a solid line shows a behavior that occurs when the inductance-containing unit 30 is "present," and a graph indicated by a broken line shows a behavior that occurs when the inductance-containing unit 30 is "absent." It is assumed that in a case where a power source is connected to the drain terminal 21, a GND is connected to the source terminal 22 and the gate terminal 23.

As shown in Fig. 7A, when the switching operation from an "ON state" to an "OFF state" is started, the drain voltage rapidly rises from the GND (0 V), and comes closer to a steady-state value while attenuating vibration. As understood from Fig. 7A, the surge when the inductance-containing unit 30 is "present" is significantly suppressed as compared with that when the inductance-containing unit 30 is "absent."

As shown in Fig. 7B, when the switching operation from an "ON state" to an "OFF state" is started, the gate current rapidly rises from the steady-state value, and comes closer to an original value (the steady-state value) while attenuating vibration. As is understood from Fig. 7B, the surge when the inductance-containing unit 30 is "present" is significantly suppressed as compared with that when the inductance-containing unit 30 is "absent."

When such a configuration of the power device 10B is adopted, a filter effect of suppressing high frequency noise due to a surge can be obtained. Note that the above-described operation and effects can be obtained not only in the embodiment of the power device 10B but also in the other embodiments.

### [Third Embodiment]

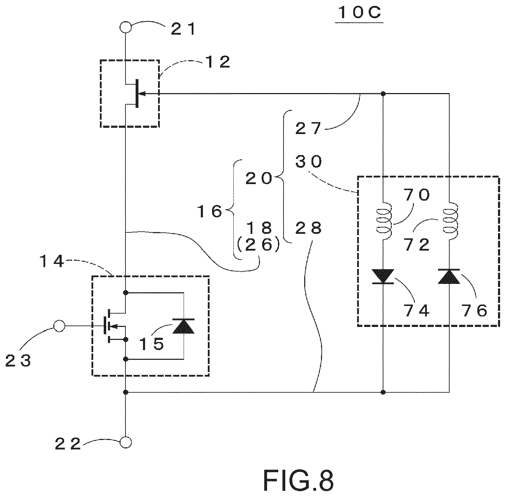

A power device 10C according to a third embodiment will be described with reference to Fig. 8. An inductance-containing unit 30 of the power device 10C illustrated in Fig. 8 includes two inductors 70, 72 that are connected to each other in parallel, a diode 74 that is connected to the inductor 70 in series, and a diode 76 that is connected to the inductor 72 in series. In other words, the inductance component 32 comprises a plurality of (herein two) inductors 70, 72.

An anode side of the diode 74 is connected to the inductor 70, and a cathode side of the diode 74 is connected to the second source (S) side of the second transistor 14. An anode side of the diode 76 is connected to the second source (S) side of the second transistor 14, and a cathode side of the diode 76 is connected to the inductor 72. In other words, the two diodes 74, 76 are connected to each other in parallel on the electric path 16 so that rectifying action directions of the two diodes 74, 76 do not coincide with each other, and the diodes 74, 76 are connected to the inductors 70, 72 in series, respectively.

A plurality of inductors 70, 72 having different frequency characteristics are used to thereby enable high frequency filters different depending on charge/discharge direction to be selected by the rectifying actions of the diodes 74, 76. An inverse voltage of the inductors 70, 72 is reduced, thereby capable of preventing an excess voltage from being applied to the second source (S) of the second transistor 14.

### [Fourth Embodiment]

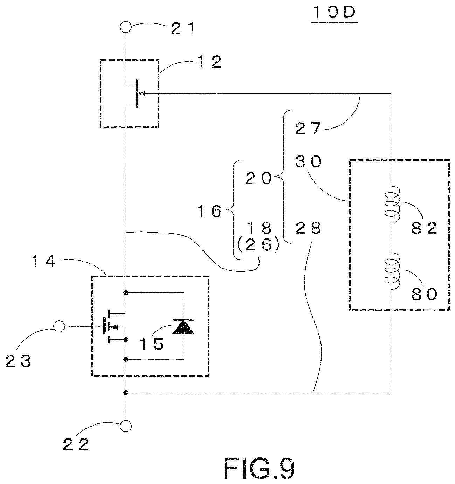

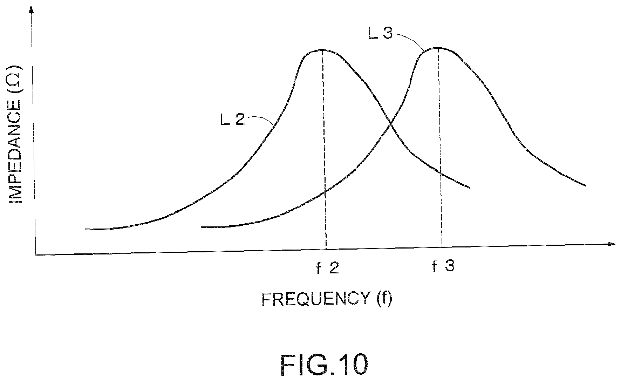

A power device 10D according to a fourth embodiment will be described with reference to Fig. 9 and Fig. 10. An inductance-containing unit 30 of the power device 10D illustrated in Fig. 9 includes two inductors 80, 82 that are connected to each other in series. In other words, the inductance component 32 comprises a plurality of (two herein) inductors 80, 82.

The abscissa of the graph shown in Fig. 10 represents a frequency (f; Hz in unit), and the ordinate represents impedances (Ω in unit) of the inductors 80, 82. Note that in an example of Fig. 10, the impedance is adopted as a physical quantity (ordinate) of the "frequency characteristic," but the ordinate may represent an inductance (H in unit).

The inductor 80 has a band rejection filter type frequency characteristic L2 having one peak centering on a peak frequency f2. The inductor 82 has a band rejection filter type frequency characteristic L3 having one peak centered on a peak frequency f3 (> f2). In this case, the impedance of the inductance-containing unit 30 is equivalent to a sum (L2 + L3) of both impedances.

When a plurality of (two herein) inductors 80, 82 having different frequency characteristics L2, L3 are thus connected to each other in series on the electric path 16, the ranges of the frequency characteristics can be mutually covered. As a result, an effective band width of the high frequency filter can be substantially increased.

### [Operation and Effects Common to Each Embodiment]

As described above, the power device 10 (10A to 10D) includes
[1] a normally-on type first transistor 12 that uses a GaN-based compound semiconductor, the normally-on type first transistor 12 including a first gate (G), a first source (S), and a first drain (D),
[2] a normally-off type second transistor 14 including a second gate (G), a second source (S), and a second drain (D), and
[3] an electric path 16 that forms cascode connections between the first gate (G) of the first transistor 12 and the second source (S) of the second transistor 14, and between the first source (S) of the first transistor 12 and the second drain (D) of the second transistor 14, and contains an inductance-containing unit 30 between the first transistor 12 and the second transistor 14. Since the electric path 16 forming the cascode connection between the first transistor 12 and the second transistor 14 contains an inductance component 32, a filtered voltage is applied to the cascode connection side, and the filter includes a filter that reflects the frequency characteristic of the inductance component 32, and a high frequency filter that cuts off many frequency components belonging to the high frequency band.

Even when the frequency of the noise component to be addressed is increased, it is not necessary to greatly change the filter as long as the frequency is higher than a cutoff frequency. Thus, it is possible to easily design the switching circuit that takes measures against high frequency noise while maintaining the high switching speed without change.

It is more preferable to provide the inductance component 32 in an electric path (the path portion 20) between the first gate (G) of the first transistor 12 and the second source (S) of the second transistor 14. When the inductance component 32 is thus disposed in the electric path, the effect of suppressing the surges of both the gate terminal 23 and the drain terminal 21 can be obtained without impairing the switching speed.

It is preferable that the inductance component 32 is comprised of the inductors 40, 60, 70, 72, 80, 82 having the frequency characteristic of suppressing or removing the surge that occurs along with the switching operation. Thus, the inductance component is hardly affected by the surge that occurs along with the switching operation.

### [Remarks]

Note that the present invention is not limited to the above-described embodiments, and can be freely changed without departing from the scope of the invention. The respective configurations in the embodiments described above can be appropriately combined as long as a technical inconsistency does not occur, for example.

### List of Reference Signs

10 (A/B/C/D) power device,
12 first transistor,
14 second transistor,
15 parasitic diode,
16 electric path,
18, 20 path portion,
21 drain terminal,
22 source terminal,
23 gate terminal,
26 to 28 electric wire,
30 inductance-containing unit,
32 inductance component,
40, 60, 70, 72, 80, 82 inductor,
42 substrate,
43 electron transit layer,
44 electron supply layer,
46 gate electrode pad,
48 bonding wire (electric wire),
50 magnetic thin film (magnetic member),
52 chip bead (magnetic member),
53 microstrip line,
54 conductive foil (transmission line),
55 substrate,
56 conductive foil (GND),
62, 66 resistor,
74, 76 diode

## Claims

1. A power device comprising:
a normally-on type first transistor that uses a GaN-based compound semiconductor, the normally-on type first transistor including a first gate, a first source, and a first drain;
a normally-off type second transistor including a second gate, a second source, and a second drain; and
an electric path that forms cascode connections between the first gate of the first transistor and the second source of the second transistor, and between the first source of the first transistor and the second drain of the second transistor, and contains an inductance component between the first transistor and the second transistor.

2. The power device according to claim 1, wherein
the inductance component is provided in the electric path between the first gate of the first transistor and the second source of the second transistor.

3. The power device according to claim 2, wherein
the inductance component is an inductor having a frequency characteristic of suppressing or removing a surge that occurs along with a switching operation.

4. The power device according to claim 3, wherein
the inductance component comprises a plurality of inductors having the frequency characteristics different from each other,
the plurality of inductors are connected to each other in parallel on the electric path, and
a plurality of diodes of which rectifying action directions do not coincide with each other are connected to the respective plurality of inductors in series.

5. The power device according to claim 3, wherein
the inductance component comprises a plurality of inductors having the frequency characteristics different from each other, and
the plurality of inductors are connected to each other in series on the electric path.

6. The power device according to any one of claims 1 to 5, wherein
the inductance component is a magnetic member that is disposed or formed on a gate electrode pad included in the first transistor.

7. The power device according to any one of claims 1 to 5, wherein
the inductance component is a microstrip line that is formed on a gate electrode pad included in the first transistor.
